# FASCICULE DE BREVET EUROPEEN

(11) **EP 4 232 295 B1**
(45) Date de publication et mention de la délivrance du brevet: **02.07.2025**
(21) Numéro de dépôt: 21794359.6
(22) Date de dépôt: 15.10.2021
(51) Int. Cl.: B41J 3/407, B05B 13/04, B25J 11/00, H05K 3/12, B05B 12/00

(54) **PROCÉDÉ D'IMPRESSION DE PISTES CONDUCTRICES SUR UN OBJET ET PROCÉDÉ DE FONCTIONNALISATION ÉLECTRONIQUE ASSOCIÉ**
VERFAHREN ZUM DRUCKEN VON LEITERBAHNEN AUF EIN OBJEKT UND ZUGEHÖRIGES ELEKTRONISCHES FUNKTIONALISIERUNGSVERFAHREN
METHOD FOR PRINTING CONDUCTIVE TRACKS ON AN OBJECT AND ASSOCIATED ELECTRONIC FUNCTIONALISATION METHOD

(30) Priorité: 22.10.2020 FR 2010861
(43) Date de publication de la demande: 30.08.2023
(73) Titulaire: Institut Polytechnique de Grenoble, 38000 Grenoble (FR); Université Grenoble Alpes, 38400 Saint-Martin-d'Hères (FR); Centre national de la recherche scientifique, 75016 Paris (FR)
(72) Inventeur: MARIN, Philippe, 38570 TENCIN (FR); FURIA, Gioia, 38530 PONTCHARRA (FR); CHAUSSY, Didier, 38320 BRIE ET ANGONNES (FR); BENEVENTI, Davide, 38400 SAINT MARTIN D'HERES (FR)
(74) Mandataire: Hautier IP
(86) Numéro de dépôt international: PCT/EP2021/078676
(87) Numéro de publication internationale: WO 2022/084197

(56) Documents cités:
- EP-A1- 2 537 642
- EP-A1- 3 235 355
- US-A1- 2012 075 399
- US-A1- 2018 264 640
- US-A1- 2020 163 220

## Description

### DOMAINE TECHNIQUE DE L'INVENTION

La présente invention concerne le domaine des systèmes et procédés d'impression d'une piste conductrice à la surface d'un objet. Elle trouve pour application particulièrement avantageuse le domaine de la fonctionnalisation électronique d'objets quelle que soit leur géométrie.

### ÉTAT DE LA TECHNIQUE

Il existe plusieurs méthodes d'impression de pistes conductrices sur une surface d'un objet tridimensionnel (3D).

En particulier, le document de brevet WO 2016/097932 propose de mettre en oeuvre :
- un robot à plusieurs degrés de liberté pour saisir et déplacer un objet sur lequel des pistes conductrices sont à imprimer et
- une tête d'impression par jet d'encre pour éjecter une encre conductrice à la surface de l'objet,
le robot est configuré pour ajuster la position de l'objet pendant l'impression, de sorte que l'objet se déplace le long d'un trajet spatial prédéterminé par rapport à la tête d'impression, la tête d'impression étant à chaque instant sensiblement perpendiculaire à une surface cible de l'objet à imprimer audit instant.

Un inconvénient du système selon le document de brevet WO 2016/097932 est qu'il n'est pas, ou est pour le moins mal, adapté à une mise en place sur une ligne de production. Il nécessiterait effectivement un arrêt de la ligne de production au moins pour changer l'objet à fonctionnaliser. En outre, pour assurer la précision de positionnement des pistes conductrices, il serait nécessaire de savoir précisément comment l'objet a été saisi par le robot, ce qui présente des difficultés certaines, relativement incompatible avec le niveau d'industrialisation souhaité. Par ailleurs, le système selon le document de brevet WO 2016/097932 est limité à des objets de taille, de forme, et surtout de poids, compatibles avec les capacités de manutention du robot. Un autre exemple de procédé d'impression est donné dans le document de brevet EP 3235355 A1.

Un objet de la présente invention est donc de proposer un procédé d'impression d'une piste conductrice à la surface d'un objet qui permette de pallier au moins un des inconvénients susmentionnés. Un autre objet de la présente invention est de proposer un procédé de fonctionnalisation électronique d'un objet permettant de réduire le temps entre conception et fabrication de prototypes, voire de préséries, de l'objet.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, on prévoit, selon un premier aspect de l'invention, un procédé d'impression d'au moins une piste conductrice à la surface d'un objet. Le procédé met en œuvre au moins un robot à bras possédant plusieurs degrés de liberté et au moins une tête d'impression d'encre conductrice. Au moins une partie de l'objet est disposée dans un espace de travail dudit au moins un robot.

Le procédé d'impression comprend les étapes suivantes :
- Réaliser un scan 3D d'une partie au moins de la surface de l'objet à l'aide d'un scanner monté sur un bras du robot qui en assure le déplacement relativement à l'objet,
- Construire, à partir du scan 3D réalisé, un modèle numérique de la partie scannée de la surface de l'objet à l'aide d'un logiciel CAO,
- Dessiner numériquement, sur le modèle numérique précédemment construit, une piste conductrice à l'aide du logiciel CAO,
- Générer, en fonction du dessin de la piste conductrice, une trajectoire pour la tête d'impression à l'aide du logiciel CAO, et
- Imprimer ladite au moins une piste conductrice à l'aide de la tête d'impression montée sur un bras du robot qui en assure le déplacement relativement à l'objet en suivant la trajectoire précédemment générée.

Ainsi, le procédé selon le premier aspect de l'invention permet la réalisation d'opérations de scan 3D et d'impression d'encres conductrices :
- de façon flexible et modulaire, et/ou
- de façon simple en termes d'utilisation et de programmation, et/ou
- avec logiciel et interface d'utilisation simplifiés, et/ou
- en un temps réduit par rapport à l'existant, entre la conception et la fabrication de prototypes ou de préséries, et/ou
- de façon compatible avec des environnements industriels, et/ou
- de façon intégrable sur des lignes de production automatiques existantes.

De manière facultative, le procédé d'impression tel qu'introduit ci-dessus peut en outre présenter au moins l'une quelconque des caractéristiques suivantes qui peuvent être prises séparément ou en combinaison.

Selon un exemple, l'objet est un objet tridimensionnel.

Selon un autre exemple, le procédé comprend en outre, suite à l'étape de réalisation du scan 3D de l'objet et avant l'étape de construction dudit modèle numérique, une étape consistant à repérer la position de l'objet par rapport à un repère de référence (TCP pour « Tool Center Point ») dudit au moins un robot.

Selon un autre exemple, le dessin de la piste conductrice est réalisé directement sur le modèle numérique construit ou est généré par projection d'un modèle numérique bidimensionnel (2D) de la piste conductrice sur le modèle numérique construit.

Selon un autre exemple, ledit au moins un robot comprend au moins un robot à bras articulé à six axes.

Selon un autre exemple, le scanner comprend un capteur à triangulation laser. Le capteur à triangulation laser peut comprendre au moins l'un parmi un capteur à spot laser et un capteur à ligne laser.

Selon un autre exemple, l'étape d'impression comprend également la mise en œuvre de systèmes de dosage par contact (extrusion pneumatiques ou volumétriques à travers des aiguilles) ou sans contact (jet piézo-électrique de gouttes d'encre).

Selon un autre exemple, plusieurs pistes conductrices sont imprimées qui forment ensemble au moins un circuit imprimé.

Selon un autre exemple, le procédé comprend en outre une étape de traitement d'au moins une piste conductrice à l'aide d'une valve de pulvérisation montée sur un bras du robot qui en assure le déplacement relativement à l'objet, le cas échéant en suivant la trajectoire précédemment générée.

Selon un autre exemple, le procédé comprend en outre, préalablement à l'étape de réalisation du scan 3D, une étape d'initialisation comprenant la génération un modèle numérique de l'un au moins parmi le scanner, la tête d'impression et un éventuel système de dosage associé, une machine pick-and-place avec dispositif de vision intégré et une valve de pulvérisation.

Selon un autre exemple, au moins deux parmi le scanner, la tête d'impression et un éventuel système de dosage associé, une machine pick-and-place avec dispositif de vision intégré et une valve de pulvérisation sont montés sur un même bras du robot.

En alternative ou en complément à l'exemple précédent, au moins deux parmi le scanner, la tête d'impression et un éventuel système de dosage associé, une machine pick-and-place avec dispositif de vision intégré et une valve de pulvérisation sont montés sur des bras de robot(s) différents entre eux. Selon cet exemple, un convoyeur peut être prévu qui est configuré pour convoyer l'objet d'un espace de travail d'un premier robot à un espace de travail d'un autre robot. En alternative ou en complément, au moins deux robots sont agencés à des postes différents entre eux, et éventuellement successifs, d'une même ligne de production.

Un autre aspect de l'invention concerne un produit programme d'ordinateur comprenant des instructions, qui lorsqu'elles sont effectuées par au moins un processeur, exécute au moins les étapes du procédé d'impression tel qu'introduit ci-dessus.

Un autre aspect de l'invention concerne un procédé de fonctionnalisation électronique d'un objet, comprenant :
- le procédé d'impression d'au moins une piste conductrice à la surface d'un objet tel qu'introduit ci-dessus, de sorte à imprimer sur l'objet une pluralité de pistes conductrices formant un circuit imprimé et
- le placement de composants électroniques en des endroits prédéfinis du circuit imprimé à l'aide d'une machine « pick-and-place », avec dispositif de vision intégré, montée sur un bras du robot.

Ainsi, le procédé selon le premier aspect de l'invention permet le positionnement de composants électroniques de sorte à fonctionnaliser électroniquement un objet :
- de façon flexible et modulaire, et/ou
- de façon simple en termes d'utilisation et de programmation, et/ou
- avec logiciel et interface d'utilisation simplifiés, et/ou
- en un temps réduit par rapport à l'existant, entre la conception et la fabrication de prototypes ou de préséries, et/ou
- de façon compatible avec des environnements industriels, et/ou
- de façon intégrable sur des lignes de production automatiques existantes.

Un autre aspect de l'invention concerne un produit programme d'ordinateur comprenant des instructions, qui lorsqu'elles sont effectuées par au moins un processeur, exécute au moins les étapes du procédé de fonctionnalisation électronique tel qu'introduit ci-dessus.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente un ordinogramme d'un mode de réalisation du procédé d'impression de pistes conductrices à la surface d'un objet selon le premier aspect de l'invention et d'un mode de réalisation du procédé de fonctionnalisation électronique d'un objet selon un autre aspect de l'invention.
La figure 2 représente le robot à bras 2 mis en œuvre selon un mode de réalisation des procédés selon l'invention.
La figure 3 représente une vue éclatée des différents outils et de leur support fixés sur le robot à bras tel qu'illustré sur la figure 2.
La figure 4 représente une vue en perspective d'un objet tel que fonctionnalisé par mise en œuvre des procédés selon l'invention.

Les dessins sont donnés à titre d'exemples et ne sont pas limitatifs de l'invention. Ils constituent des représentations graphiques destinées à faciliter la compréhension de l'invention et ne sont pas nécessairement à l'échelle des applications pratiques.

### DESCRIPTION DÉTAILLÉE DE L'INVENTION

On entend, par machine « pick-and-place », une machine de prise et de positionnement.

On entend, par « circuit imprimé », un ensemble de pistes conductrices agencées entre elles sur un support, ici matérialisé par l'objet, et permettant de relier électriquement un ensemble de composants électroniques entre eux, dans le but de réaliser un circuit électronique.

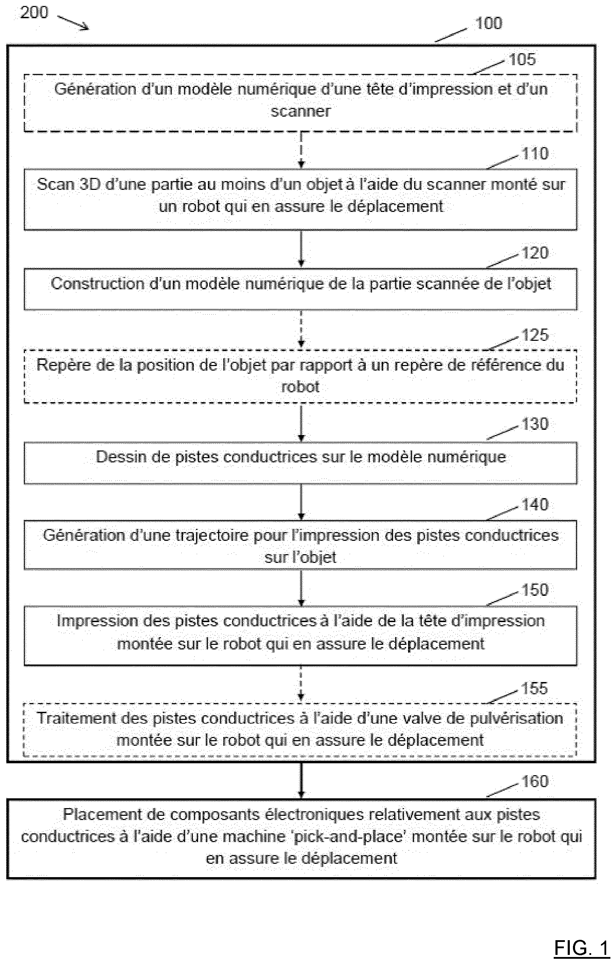

En référence à la figure 1, un mode de réalisation du premier aspect de l'invention prévoit l'impression 100 de pistes conductrices 10 à la surface d'un objet 1 par mise en œuvre d'un robot à bras 2 possédant plusieurs degrés de liberté et d'au moins une tête d'impression 3 d'encre conductrice. Le robot 2 peut plus particulièrement être robot à bras articulé à six axes. Un tel robot est avantageusement d'usage industriel maîtrisé et courant.

Contrairement au procédé d'impression décrit dans le document WO 2016/097932, c'est ici l'objet 1 qui est disposé dans un espace de travail du robot 2 ; les outils nécessaires à l'impression sont portés par le robot 2 qui en assure le déplacement relativement à l'objet 1.

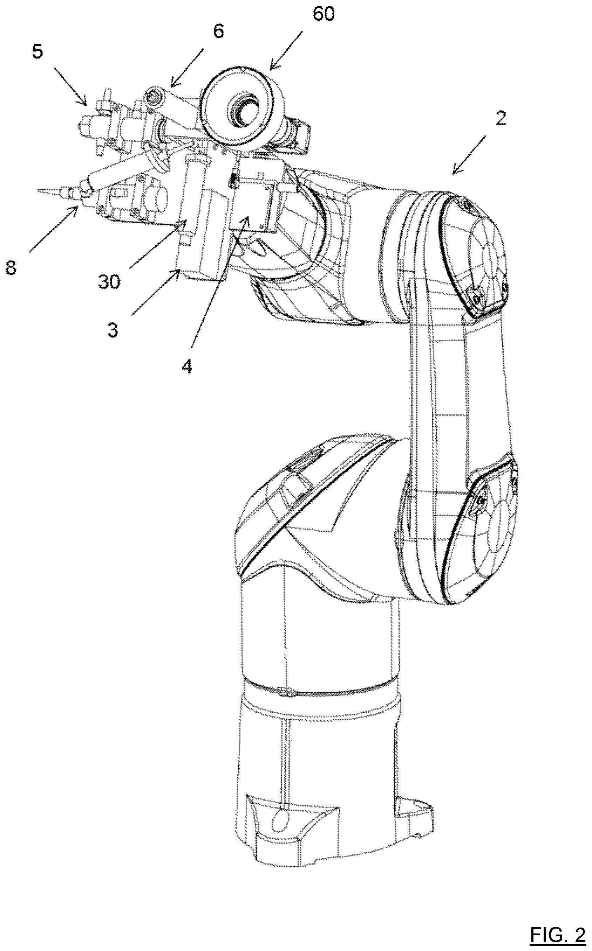

Ainsi, et comme illustré sur les figures 1 à 4, le procédé 100 comprend les étapes suivantes :
- Réaliser 110 un scan 3D d'une partie au moins de la surface de l'objet 1 à l'aide d'un scanner 4 monté sur un bras du robot 2 qui en assure le déplacement relativement à l'objet 1,
- Construire 120, à partir du scan 3D réalisé 110, un modèle numérique de la partie scannée de la surface de l'objet 1 à l'aide d'un logiciel CAO,
- Dessiner 130 numériquement, sur le modèle numérique précédemment construit 120, une piste conductrice 10 à l'aide du logiciel CAO,
- Générer 140, en fonction du dessin 130 de la piste conductrice 10, une trajectoire pour la tête d'impression 3 à l'aide du logiciel CAO, et
- Imprimer 150 ladite au moins une piste conductrice 10 à l'aide de la tête d'impression 3 montée sur un bras du robot 2 qui en assure le déplacement relativement à l'objet 1 en suivant la trajectoire précédemment générée 140.

On notera que, notamment pour les besoins du scan 3D, l'objet et plus particulièrement la surface de l'objet à scanner 110, est de préférence opaque ou rendue opaque. On notera également que l'objet peut avantageusement être un objet dit multi-matériaux.

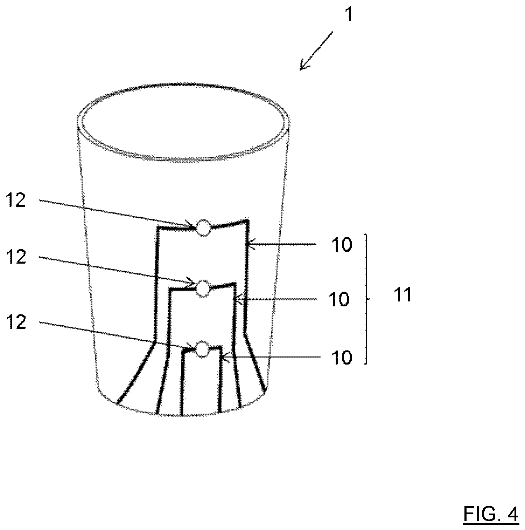

Toujours en référence à la figure 1, mais également en référence à la figure 4, un mode de réalisation d'un deuxième aspect de l'invention prévoit de poursuivre le procédé d'impression 100 selon son premier aspect par une étape de placement 160 de composants électroniques 12, en des endroits prédéfinis d'un circuit imprimé 11 constitué une pluralité de pistes conductrices 10, à l'aide d'une machine « pick-and-place » 6, avec dispositif de vision intégré 60, montée sur le bras du robot 2, de sorte à fonctionnaliser électroniquement l'objet 1.

Ainsi, l'objet 1 reste dans une même position lors du procédé d'impression 100 et le cas échéant du procédé de fonctionnalisation 200. Ce sont les outils nécessaires à l'impression 100 et le cas échéant à la fonctionnalisation 200 qui se déplacent relativement à l'objet 1 grâce à leur fixation sur le bras du robot 2.

Dès lors, l'objet 1 peut être de tout poids. En effet, l'objet 1 repose par exemple sur une plate-forme, définissant espace de travail du robot 2, qui peut être adapté à la réception d'un objet de n'importe quel poids. L'objet 1 peut encore être de n'importe quelle forme. Le scanner étant configuré pour réaliser un scan 3D, l'objet n'est effectivement pas limité à une forme 2D ; la partie scannée de l'objet 1 peut présenter une surface courbe. En outre, le scan 3D peut ne concerner qu'une partie de l'objet 1. Dès lors que la partie de l'objet 1 concernée par le scan 3D entre dans l'espace de travail du robot, l'objet 1 peut être de toutes dimensions. Au contraire, dans le système d'impression décrit dans le document WO 2016/097932, l'objet est nécessairement d'un poids réduit pour pouvoir être déplacé par le robot (un robot à bras six axes peut généralement permettre de déplacer des objets d'un poids au plus égal à 3 kg), d'une forme permettant sa préhension par le robot, et de dimensions limitées par celles de l'espace de travail du robot.

En outre, dans l'optique d'une industrialisation, les procédés 100 et 200 selon l'invention présentent l'avantage, contrairement au système d'impression décrit dans le document WO 2016/097932, de ne pas requérir l'arrêt de la ligne de production à chaque changement d'objet à fonctionnaliser. Deux ou trois robots 2 peuvent même, selon l'invention, être prévus pour agir simultanément ou successivement sur l'objet 1. Par exemple, au moins deux robots 2 sont agencés à des postes différents entre eux, et éventuellement successifs, d'une même ligne de production. En outre, l'utilisation de plusieurs robots 2 portants chacun un ou plusieurs des outils nécessaires à l'impression 100 et le cas échéant à la fonctionnalisation 200 peut être prévue conjointement avec celle d'un convoyeur configuré pour convoyer l'objet d'un espace de travail d'un premier robot à un espace de travail d'un robot suivant le long de la ligne de production.

La présente invention permet par ailleurs de s'affranchir de difficultés, inhérentes au système d'impression décrit dans le document WO 2016/097932, de définition de la façon dont le robot a saisi l'objet. En effet, l'objet 1 pouvant rester, durant les procédés 100 et 200 selon l'invention en position fixe, il peut être suffisant de s'assurer de connaître avec une précision suffisante le positionnement initial de l'objet 1 pour mettre en œuvre l'invention. Au besoin, il peut être prévu une étape consistant à repérer 125 la position de l'objet 1 par rapport à un repère de référence (TCP pour « Tool Center Point ») du robot 2, notamment suite au scan 3D 110 et avant l'étape de construction (120) dudit modèle numérique, de sorte à s'assurer que les étapes du procédé réalisées à l'aide du logiciel CAO le soient avec précision. En effet, la calibration du robot 2 et le positionnement automatique du robot 2 relativement à l'objet 1 sont, par cette étape de repérage 125, rendus possibles, même si le positionnement de l'objet 1 dans l'espace de travail du robot 2 n'est pas prédéfini.

Un autre intérêt du procédé d'impression selon le premier aspect de l'invention réside dans le fait qu'il est compatible avec une réalisation du dessin 130 de la piste conductrice 10 soit directement sur le modèle numérique construit 120, soit par projection d'un modèle numérique 2D de la piste conductrice 10 sur le modèle numérique construit 120.

En outre, préalablement à l'étape de réalisation 110 du scan 3D, il est aisé de réaliser, potentiellement une fois pour toutes, une étape d'initialisation comprenant la génération 105 d'un modèle numérique de l'un au moins parmi la tête d'impression 3 et un éventuel système de dosage 30 associé, le scanner 4, une valve de pulvérisation 5, et une machine pick-and-place 6 avec dispositif de vision intégré 60. Ainsi, la distance de chaque outil à chaque instant où il est sollicité relativement à l'objet 1 peut être déterminée numériquement avec une grande précision, et potentiellement pour toute la durée d'utilisation d'un robot 2 équipé des mêmes outils. Il est à noter qu'il est possible de s'assurer de cela d'autres façons, faisant par exemple intervenir un capteur de distance, tel qu'un capteur laser, et/ou un dispositif de vision, tel qu'une caméra.

Un mode de réalisation spécifique d'une cellule robotique mise en œuvre selon le procédé d'impression 100 et le cas échéant le procédé de fonctionnalisation 200 va maintenant être décrit à titre d'exemple non limitatif.

Le robot à bras 2 peut plus particulièrement comprendre un bras robotisés 6 axes de la gamme TX2-60 et son contrôleur CS9 proposés par la société Stäubli. Le contrôleur CS9 peut en outre être associé à un boîtier de commande manuel SP2.

La tête d'impression 3 peut plus particulièrement comprendre une valve de microdosage telle que celle proposée sous la référence MDV 3200A par la société VERMES et une pompe doseuse volumétrique de précision.

Le système de dosage 30 associé à la tête d'impression 3 peut plus particulièrement comprendre un pompe doseuse volumétrique de précision, telle que celle commercialisée sous la marque preeflow^{®} eco-PEN300.

Le scanner 4 peut plus particulièrement comprendre un des capteurs laser proposés par la société Micro-Epsilon, et notamment celui commercialisé sous la référence optoNCDT 1420.

La valve de pulvérisation 5 peut plus particulièrement comprendre une soupape de pulvérisation en acier inoxydable telle que celle commercialisée sous la référence SV1000SS par la société FISNAR^{®}. Elle peut être utilisée en complément des têtes d'impression 3 et 8 pour le dépôt i) d'encres conductrices sur des grandes surfaces ou ii) un vernis pour la protection des circuits électroniques.

La machine pick-and-place 6 peut plus particulièrement comprendre un dispositif de vision industriel CV-X400 et les périphériques associés, tel que proposé par la société KEYENCE.

Le dispositif de vision 60 intégré à la machine pick-and-place 6 peut plus particulièrement comprendre une caméra et un éclairage annulaire à LEDs. La fonction de préhension et de déplacement peut plus particulièrement être réalisée par un capillaire de préhension des composants électroniques relié à une pompe à vide via une électrovanne pilotée par le contrôleur du robot à bras 2.

Une valve de dosage à pointeau 8 peut en outre être prévue qui comprend une cartouche pressurisée contenant l'encre conductrice à déposer et une vanne pneumatique à pointeau pilotée par le contrôleur du robot à bras 2. Cette valve peut plus particulièrement être l'une de celles commercialisées par la société VIEWEG^{®}.

Notons que chacun parmi la tête d'impression 3 et son système de dosage 30, le scanner 4, la valve de pulvérisation 5 et la valve de dosage 8 peuvent être fonctionnellement reliés et communiqués avec le contrôleur du robot à bras 2, le cas échéant via un contrôleur et/ou en convertisseur adapté.

En outre, ces différents éléments sont connectés entre eux via différentes connexions tels que des bus esclaves RT Ethernet, un bus maître EtherCAT, des ports Ethernet TCP/IP et des ports série RS232 et d'autres connexions modulaires (E/S numériques, E/S analogiques).

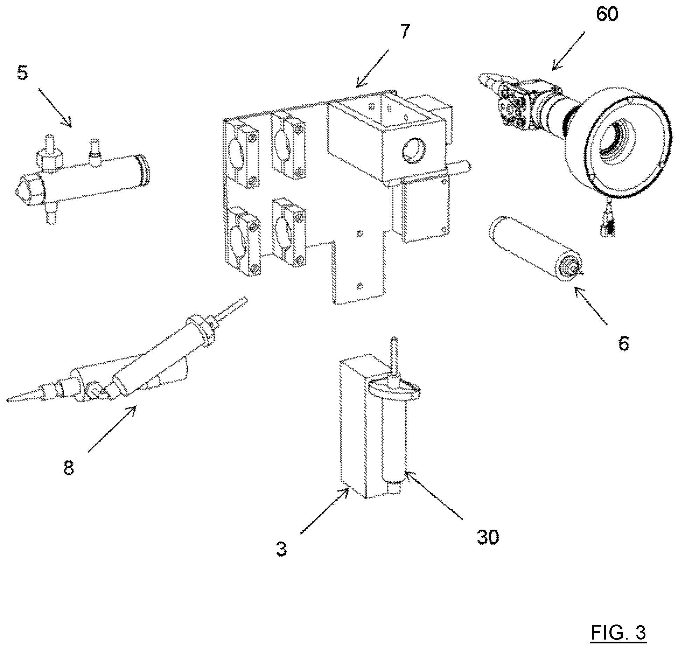

Notons également, en référence à la figure 3, que les différents outils utilisés selon le mode de réalisation choisi, et notamment celui illustré pour lequel tous les outils 3, 4, 5, 6 et 8 utilisés sont fixés à un même robot 2 peuvent l'être via un support 7 prenant par exemple la forme d'une platine.

On remarquera que cette configuration spécifique, comme d'autres envisageables, présentent les avantages suivants :
- un coût de cellule inférieur à 150 k€,
- un temps d'installation de 30 à 60 minutes, et
- une facilité d'apprentissage, c'est-à-dire un temps de formation d'environ % journée.

Le tout peut être agencé conjointement avec une cellule. La cellule définit par exemple tout ou partie de l'espace de travail du robot 2. Une majorité d'éléments 2, 3, 4, 5, 6, 7 et 8 peut être agencée dans la cellule.

Une telle cellule robotique répond aux besoins des laboratoires de recherche ou généralement des petites entreprises, c'est-à-dire qu'elle est adaptée pour être exploitée par des personnes sans compétence particulière en robotique, et pour la fabrication de prototypes avec un temps de mise en place aussi court que possible. La cellule est également conçue, installée et entretenue à moindre coût.

Une interface dédiée est proposée qui a été développée pour faire le lien avec un langage et un environnement de programmation visuelle qui s'exécutent dans l'application Rhinoceros 3D, et qui est connue sous l'appellation Grasshopper^{®}, pour automatiser tout le processus, la création et le transfert du programme du robot 2 pour rendre la cellule utilisable par des personnes sans compétence en robotique.

On remarquera également que la platine 7 et les différents outils 3, 4, 5, 6 et 8 potentiellement fixés dessus présentent un poids total avantageusement inférieur à 3 kg.

Par ailleurs, la sécurité de l'utilisateur peut être assurée par un arrêt automatique installé sur une porte de la cellule. Ainsi, lorsque le robot 2 fonctionne en mode automatique, l'ouverture de la porte provoque l'arrêt immédiat du robot 2.Le défaut causé doit être corrigé par un bouton spécifique afin de permettre au robot 2 de se remettre sous tension. De plus, tout arrêt d'urgence par appui sur un bouton d'alerte rouge provoque également l'arrêt immédiat du robot 2.

L'invention n'est pas limitée aux modes de réalisations précédemment décrits et s'étend à tous les modes de réalisation couverts par les revendications.

## Revendications

1. Procédé d'impression (100) d'au moins une piste conductrice (10) à la surface d'un objet (1), le procédé (100) mettant en œuvre au moins un robot à bras (2) possédant plusieurs degrés de liberté et au moins une tête d'impression (3) d'encre conductrice, au moins une partie de l'objet (1) étant disposée dans un espace de travail dudit au moins un robot (2), le procédé (100) comprenant les étapes suivantes :
• Réaliser (110) un scan 3D d'une partie au moins de la surface de l'objet (1) à l'aide d'un scanner (4) monté sur un bras du robot (2) qui en assure le déplacement relativement à l'objet (1),
• Construire (120), à partir du scan 3D réalisé (110), un modèle numérique de la partie scannée de la surface de l'objet (1) à l'aide d'un logiciel CAO,
• Dessiner (130) numériquement, sur le modèle numérique précédemment construit (120), une piste conductrice (10) à l'aide du logiciel CAO,
• Générer (140), en fonction du dessin (130) de la piste conductrice (10), une trajectoire pour la tête d'impression (3) à l'aide du logiciel CAO, et
• Imprimer (150) ladite au moins une piste conductrice (10) à l'aide de la tête d'impression (3) montée sur un bras du robot (2) qui en assure le déplacement relativement à l'objet (1) en suivant la trajectoire précédemment générée (140).

2. Procédé (100) selon la revendication précédente, comprenant en outre, suite à l'étape de réalisation (110) du scan 3D de l'objet (1) et avant l'étape de construction (120) dudit modèle numérique, une étape consistant à repérer (125) la position de l'objet (1) par rapport à un repère de référence dudit au moins un robot (2).

3. Procédé (100) selon l'une quelconque des revendications précédentes, dans lequel le dessin (130) de la piste conductrice (10) est réalisé directement sur le modèle numérique construit (120) ou est généré par projection d'un modèle numérique bidimensionnel de la piste conductrice (10) sur le modèle numérique construit (120).

4. Procédé (100) selon l'une quelconque des revendications précédentes, dans lequel ledit au moins un robot (2) comprend au moins un robot à bras articulé à six axes.

5. Procédé (100) selon l'une quelconque des revendications précédentes, dans lequel le scanner (4) comprend un capteur à triangulation laser.

6. Procédé (100) selon la revendication précédente, dans lequel le capteur à triangulation laser comprend au moins l'un parmi un capteur à spot laser et un capteur à ligne laser.

7. Procédé (100) selon l'une quelconque des revendications précédentes, dans lequel l'étape d'impression (3) comprend également la mise en œuvre de systèmes de dosage (30) par contact ou sans contact.

8. Procédé (100) selon l'une quelconque des revendications précédentes, dans lequel plusieurs pistes conductrices (10) sont imprimées (150) qui forment ensemble au moins un circuit imprimé (11).

9. Procédé (100) selon l'une quelconque des revendications précédentes, comprenant une étape de traitement (155) d'au moins une piste conductrice (10) à l'aide d'une valve de pulvérisation (5) montée sur un bras du robot (2) qui en assure le déplacement relativement à l'objet (1), le cas échéant en suivant la trajectoire précédemment générée (140).

10. Procédé (100) selon l'une quelconque des revendications précédentes, comprenant, préalablement à l'étape de réalisation (110) du scan 3D, une étape d'initialisation comprenant la génération (105) d'un modèle numérique de l'un au moins parmi la tête d'impression (3) et un éventuel système de dosage (30) associé, le scanner (4), une valve de pulvérisation (5), et une machine pick-and-place (6) avec dispositif de vision intégré (60).

11. Procédé (100) selon l'une quelconque des revendications précédentes, dans lequel au moins deux parmi la tête d'impression (3) et un éventuel système de dosage (30) associé, le scanner (4), une valve de pulvérisation (5), et une machine pick-and-place (6) avec dispositif de vision intégré (60) sont montés sur un même bras du robot (2).

12. Procédé (100) selon l'une quelconque des revendications 1 à 10, dans lequel au moins deux parmi la tête d'impression (3) et un éventuel système de dosage (30) associé, le scanner (4), une valve de pulvérisation (5), et une machine pick-and-place (6) avec dispositif de vision intégré (60) sont montés sur des bras de robot(s) (2) différents entre eux.

13. Procédé de fonctionnalisation électronique (200) d'un objet (1), comprenant le procédé d'impression (100) d'au moins une piste conductrice (10) à la surface d'un objet (1) selon l'une quelconque des revendications précédentes de sorte à imprimer sur l'objet (1) une pluralité de pistes conductrices (10) formant un circuit imprimé (11) et le placement (160) de composants électroniques (12) en des endroits prédéfinis du circuit imprimé (11) à l'aide d'une machine « pick-and-place » (6), avec dispositif de vision intégré (60), montée sur un bras du robot (2).

14. Produit programme d'ordinateur comprenant des instructions, qui lorsqu'elles sont effectuées par au moins un processeur d'un bras de robot avec une tête d'impression, exécute au moins les étapes du procédé d'impression (100) d'au moins une piste conductrice (10) à la surface d'un objet (1) selon l'une quelconque des revendications 1 à 12.

15. Produit programme d'ordinateur comprenant des instructions, qui lorsqu'elles sont effectuées par au moins un processeur d'un bras de robot avec une tête d'impression, exécute au moins les étapes du procédé de fonctionnalisation électronique (200) d'un objet (1) selon la revendication 13.

## Patentansprüche

1. Verfahren zum Drucken (100) mindestens einer Leiterbahn (10) auf der Oberfläche eines Objekts (1), wobei das Verfahren (100) mindestens einen Armroboter (2) umsetzt, der mehrere Freiheitsgrade besitzt, und mindestens einen Druckkopf (3) für leitfähige Tinte, wobei mindestens ein Teil des Objekts (1) in einem Arbeitsraum des mindestens einen Roboters (2) angeordnet ist, wobei das Verfahren (100) die folgenden Schritte umfasst:
• Durchführen (110) eines 3D-Scans mindestens eines Teils der Oberfläche des Objekts (1) mit Hilfe eines Scanners (4), der auf einem Arm des Roboters (2) montiert ist, der dessen Verschiebung relativ zu dem Objekt (1) sicherstellt,
• Konsturieren (120), ausgehend von einem durchgeführten 3D-Scan (110), eines digitalen Modells des gescannten Teils der Oberfläche des Objekts (1) mit Hilfe einer CAD-Software,
• digitales Zeichnen (130) auf dem zuvor gebauten digitalen Modell (120) einer Leiterbahn (10) mit Hilfe der CAD-Software, CAO,
• Erzeugen (140) in Abhängigkeit von der Zeichnung (130) der Leiterbahn (10), einer Trajektorie für den Druckkopf (3) mit Hilfe der CAD-Software, und
• Drucken (150) der mindestens einen Leiterbahn (10) mit Hilfe des Druckknopfs (3), der auf einem Arm des Roboters (2) montiert ist, der dessen Verschiebung relativ zu dem Objekt (1) entlang der zuvor erzeugten Trajektorie (140) sicherstellt.

2. Verfahren (100) nach dem vorstehenden Anspruch, das außerdem im Anschluss an den Durchführungsschritt (110) des 3D-Scans des Objekts (1) und vor dem Konstruktionsschritt (120) des digitalen Modells einen Schritt umfasst, der darin besteht, die Position des Objekts 1 bezüglich einer Referenzmarkierung des mindestens einen Roboters (2) zu markieren (125).

3. Verfahren (100) nach einem der vorstehenden Ansprüche, wobei die Zeichnung (130) der Leiterbahn (10) direkt auf dem konstruierten digitalen Modell (120) durchgeführt oder durch Projektion eines bidimensionalen digitalen Modells der Leiterbahn (10) auf dem konstruierten numerischen Modell (120) erzeugt wird.

4. Verfahren (100) nach einem der vorstehenden Ansprüche, wobei der mindestens eine Roboter (2) mindestens einen sechsachsigen Knickarmroboter umfasst.

5. Verfahren (100) nach einem der vorstehenden Ansprüche, wobei der Scanner (4) einen Lasertriangulationssensor umfasst.

6. Verfahren (100) nach dem vorstehenden Anspruch, wobei der Lasertriangulationssensor mindestens einen eines Laserspotsensors und eines Laserliniensensors umfasst.

7. Verfahren (100) nach einem der vorstehenden Ansprüche, wobei der Druckschritt (3) auch das Umsetzen des Dosiersystems (30) mit oder ohne Kontakt umfasst.

8. Verfahren (100) nach einem der vorstehenden Ansprüche, wobei mehrere Leiterbahnen (10) gedruckt werden (150), die gemeinsam mindestens eine gedruckte Schaltung (11) bilden.

9. Verfahren (100) nach einem der vorstehenden Ansprüche, das einen Bearbeitungsschritt (155) mindestens einer Leiterbahn (10) mit Hilfe eines Sprühventils (5) umfasst, das auf einem Arm des Roboters (2) montiert ist, der dessen Verschiebung relativ zu dem Objekt (1) sicherstellt, gegebenenfalls entlang der zuvor erzeugten (140) Trajektorie.

10. Verfahren (100) nach einem der vorstehenden Ansprüche, das vor dem Durchführungsschritt (110) des 3D-Scans einen Initialisierungsschritt umfasst, der das Erzeugen (105) eines digitalen Modells von mindestens einem des Druckkopfes (3) und einem eventuellen zugeordneten Dosiersystem (30), dem Scanner (4), einem Sprühventil (5) und einer Be- und Entlademaschine (6) mit der eingebauten Visionsvorrichtung (60) umfasst.

11. Verfahren (100) nach einem der vorstehenden Ansprüche, wobei mindestens zwei von dem Druckkopf (3) und einem eventuellen zugeordneten Dosiersystem (30), dem Scanner (4), einem Sprühventil (5) und einer Be- und Entlademaschine (6) mit eingebauter Visionsvorrichtung (60) auf demselben Arm des Roboters (2) montiert sind.

12. Verfahren (100) nach einem der vorstehenden Ansprüche 1 bis 10, wobei mindestens zwei von dem Druckkopf (3) und einem eventuellen zugeordneten Dosiersystem (30), dem Scanner (4), einem Sprühventil (5) und einer Be- und Entlademaschine (6) mit eingebauter Visionsvorrichtung (60) auf Armen eines oder mehrerer Roboter (2), die sich voneinander unterscheiden, montiert sind.

13. Elektronisches Funktionalisierungsverfahren (200) eines Objekts (1), das das Druckverfahren (100) mindestens einer Leiterbahn (10) an der Oberfläche eines Objekts (1) nach einem der vorstehenden Ansprüche derart umfasst, dass auf das Objekt (1) eine Vielzahl von Leiterbahnen (10) gedruckt wird, die eine gedruckte Schaltung (11) bilden, und das Platzieren (160) elektronischer Bauteile (12) an vordefinierten Stellen der gedruckten Schaltung (11) mit Hilfe einer "Be- und Entlademaschine" (6) mit eingebauter Visionsvorrichtung (60), die auf einem Arm des Roboters (2) montiert ist.

14. Computerprogrammprodukt, das Anweisungen umfasst, die, wenn sie von mindestens einem Prozessor eines Roboterarms mit einem Druckkopf durchgeführt werden, mindestens die Schritte des Druckverfahrens (100) mindestens einer Leiterbahn (10) an der Oberfläche eines Objekts (1) nach einem der Ansprüche 1 bis 12 ausführen.

15. Computerprogrammprodukt, das Anweisungen umfasst, die, wenn sie von mindestens einem Prozessor eines Roboterarms mit einem Druckkopf durchgeführt werden, mindestens die Schritte des Funktionalisierungsverfahrens (200) eines Objekts (1) nach Anspruch 13 ausführen.

## Claims

1. Method (100) for printing at least one conductive track (10) on the surface of an object (1), the method (100) implementing at least one arm robot (2) having several degrees of freedom and at least one conductive ink printhead (3), at least one part of the object (1) being disposed in a working space of said at least one robot (2), the method (100) comprising the following steps:
- Performing (110) a 3D scan of at least one part of the surface of the object (1) using a scanner (4) mounted on an arm of the robot (2) which ensures its movement relative to the object (1),
- Building (120), from a performed 3D scan (110), a digital model of the scanned part of the surface of the object (1) using CAD software,
- Digitally drawing (130) a conductive track (10) on the digital model previously built (120) using CAD software,
- Generating (140), according to the drawing (130) of the conductive track (10), a trajectory for the printhead (3) using the CAD software, and
- Printing (150) said at least one conductive track (10) using the printhead (3) mounted on an arm of the robot (2) which ensures its movement relative to the object (1) by following the previously generated trajectory (140).

2. Method (100) according to the preceding claim, further comprising, following the step (110) of performing the 3D scan of the object (1) and before the step (120) of building said digital model, a step consisting of noting (125) the position of the object (1) with respect to a reference marker of said at least one robot (2).

3. Method (100) according to any one of the preceding claims, wherein the drawing (130) of the conductive track (10) is done directly on the built digital model (120) or is generated by projecting a two-dimensional digital model of the conductive track (10) on the built digital model (120).

4. Method (100) according to any one of the preceding claims, wherein said at least one robot (2) comprises at least one six-axis articulated arm robot.

5. Method (100) according to any one of the preceding claims, wherein the scanner (4) comprises a laser triangulation sensor.

6. Method (100) according to the preceding claim, wherein the laser triangulation sensor comprises at least one from among a laser spot sensor and a laser line sensor.

7. Method (100) according to any one of the preceding claims, wherein the printing step (3) also comprises the implementation of dosing systems (30) by contact or contactless.

8. Method (100) according to any one of the preceding claims, wherein several conductive tracks (10) are printed (150), which together form at least one printed circuit (11).

9. Method (100) according to any one of the preceding claims, comprising a step (155) of processing at least one conductive track (10) using a spraying valve (5) mounted on an arm of the robot (2) which ensures its movement relative to the object (1), if necessary by following the previously generated trajectory (140).

10. Method (100) according to any one of the preceding claims, comprising, prior to the step (110) of performing a 3D scan, an initialisation step comprising the generation (105) of a digital model of the at least one from among the printhead (3) and a possible associated dosing system (30), the scanner (4), a spraying valve (5), and a pick-and-place machine (6) with an integrated viewing device (60).

11. Method (100) according to any one of the preceding claims, wherein at least two from among the printhead (3) and a possible associated dosing system (30), the scanner (4), a spraying valve (5), and a pick-and-place machine (6) with an integrated viewing device (60) are mounted on one same arm of the robot (2).

12. Method (100) according to any one of claims 1 to 10, wherein at least two from among the printhead (3) and a possible associated dosing system (30), the scanner (4), a spraying valve (5), and a pick-and-place machine (6) with an integrated viewing device (60) are mounted on arms of robot(s) (2) which are different from one another.

13. Method (200) for electronically functionalising an object (1), comprising the method (100) of printing at least one conductive track (10) on the surface of an object (1) according to any one of the preceding claims, so as to print a plurality of conductive tracks (10) on the object (1) forming a printed circuit (11) and the placement (160) of electronic components (12) in predefined locations of the printed circuit (11) using a pick-and-place machine (6), with an integrating viewing device (60), mounted on an arm of the robot (2).

14. Computer program product comprising instructions, which, when they are performed by at least one processor of a robot arm with a printhead, executes at least the steps of the method (100) for printing at least one conductive track (10) on the surface of an object (1) according to any one of claims 1 to 12.

15. Computer program product comprising instructions, which, when they are performed by at least one processor of a robot arm with a printhead, executes at least the steps of the method (200) for electronically functionalising an object (1) according to claim 13.
